# EUROPEAN PATENT APPLICATION

(11) **EP 4 750 295 A1**
(43) Date of publication of application: **27.05.2026**
(21) Application number: 25195121.6
(22) Date of filing: 11.08.2025
(51) Int. Cl.: H10K 59/80

(54) **DISPLAY APPARATUS**

(30) Priority: 21.11.2024 KR 20240167671
(71) Applicant: LG Display Co., Ltd., Seoul 150-721 (KR)
(72) Inventor: JEONG, Mi Jin, Paju-si, Gyeonggi-do (KR); SHIN, Dong Chae, Paju-si, Gyeonggi-do (KR); CHOI, Sun Young, Paju-si, Gyeonggi-do (KR); JUNG, Ju Hee, Paju-si, Gyeonggi-do (KR)
(74) Representative: Viering, Jentschura & Partner mbB Patent- und Rechtsanwälte

(57) **Abstract**

The present disclosure relates to a display apparatus. The display apparatus has a display area and a non-display area surrounding the display area and comprises: a substrate (101); a first thin film transistor (200) and a second thin film transistor (300) disposed on the substrate; a light emitting device disposed on the first thin film transistor (200) and the second thin film transistor (300) and comprising a first electrode (E1), an emission layer (EL) and a second electrode (E2); and an encapsulation layer disposed on the light emitting device, wherein the first electrode (E1), the emission layer (EL) and the second electrode (E2) are formed to have a concave-convex structure in at least a portion of an emission region. The display apparatus can improve color viewing angle and light extraction efficiency.

## Description

### Field of the Invention

The present disclosure relates to a display apparatus.

### Background Art

As information-oriented society advances, various demands for display apparatuses for displaying an image are increasing. Recently, display apparatuses of various types such as liquid crystal display (LCD) apparatuses and organic light emitting diode display apparatuses are being practically used. Particularly, because organic light emitting diode display apparatuses do not need a separate light source, organic light emitting diode display apparatuses are favorable for lightness and thinness, and thus, the demand is increasing.

However, an organic light emitting diode display panel includes an emission layer which emits light, and in this case, because there are lights which do not travel to the outside of the organic light emitting diode display panel and are trapped in an organic light emitting diode display apparatus among lights emitted from the emission layer, there is a problem where the light extraction efficiency of the organic light emitting diode display panel is reduced, and due to this, emission efficiency decreases.

### SUMMARY

Embodiments of the present disclosure provide a display apparatus in which a color viewing angle may be improved, and light extraction efficiency may be enhanced.

Embodiments of the present disclosure provide a display apparatus in which a protrusion portion may be configured under an organic light emitting device, and thus, a concave-convex structure of an organic insulation layer may be easily formed.

Embodiments of the present disclosure provide a display apparatus having a structure which may prevent color mixture between adjacent subpixels.

Embodiments of the present disclosure provide a low-power display apparatus. Various embodiments of the present disclosure provide a display apparatus according to claim 1. Further embodiments are described in the dependent claims.

According to one aspect of the present disclosure, a display apparatus is provided which has a display area and a non-display area surrounding the display area and comprises: a substrate; a first thin film transistor and a second thin film transistor disposed on the substrate; a light emitting device disposed on the first thin film transistor and the second thin film transistor and comprising a first electrode, an emission layer and a second electrode; and an encapsulation layer disposed on the light emitting device, wherein the first electrode, the emission layer and the second electrode are formed to have a concave-convex structure in at least a portion of an emission region.

According to another aspect of the present disclosure, a display apparatus is provided which has a display area and a non-display area surrounding the display area and comprises: a substrate; a first thin film transistor and a second thin film transistor disposed on the substrate; a light emitting device disposed on the first thin film transistor and the second thin film transistor and comprising a first electrode, an emission layer and a second electrode; and an encapsulation layer disposed on the light emitting device, wherein the first electrode, the emission layer, and the second electrode are formed to have one or more protrusions protruding toward a front surface of the display apparatus opposite to the substrate in at least a portion of an emission region.

The objects of the present disclosure are not limited to the objects described above, and other objects not described herein will be clearly understood by those of ordinary skill in the art from descriptions below.

### BRIEF DESCRIPTION OF THE DRAWINGS

The accompanying drawings, which are included to provide a further understanding of the disclosure and are incorporated in and constitute a part of this application, illustrate embodiment(s) of the disclosure and together with the description serve to explain the principle of the disclosure. In the drawings:
FIG. 1 is a plan view of a display apparatus according to an embodiment;
FIG. 2 is a cross-sectional view illustrating a state where a display panel illustrated in FIG. 1 is bent;
FIG. 3 is a plan arrangement view of subpixels of a display area of FIG. 1;
FIG. 4 is another embodiment of FIG. 3;
FIG. 5 is a cross-sectional view taken along line A1-A1' of FIG. 3 or FIG. 4;
FIG. 6 is another embodiment of FIG. 5;
FIG. 7 is a cross-sectional view of a touch part illustrated in FIGs. 5 and 6;
FIG. 8 is a cross-sectional view taken along line B-B' of FIG. 1;
FIG. 9 is a cross-sectional view taken along line C-C' of FIG. 1;
FIG. 10 is another embodiment of FIG. 3;
FIG. 11 is another embodiment of FIG. 10;
FIG. 12 is a cross-sectional view taken along line A2-A2' of FIG. 10 or FIG. 11; and
FIG. 13 is another embodiment of FIG. 12.

### DETAILED DESCRIPTION OF THE DISCLOSURE

Hereinafter, the present disclosure will be described more fully with reference to the accompanying drawings, in which exemplary embodiments of the disclosure are shown. The disclosure may, however, be embodied in many different forms and should not be construed as being limited to the embodiments set forth herein; rather, these embodiments are provided so that this disclosure will be thorough and complete, and will fully convey the concept of the disclosure to those skilled in the art.

Advantages and features of the present disclosure, and implementation methods thereof will be clarified through following embodiments described with reference to the accompanying drawings. The present disclosure may, however, be embodied in different forms and should not be construed as limited to the embodiments set forth herein. Rather, these embodiments are provided so that this disclosure will be thorough and complete, and will fully convey the scope of the present disclosure to those skilled in the art. Furthermore, the present disclosure is only defined by scopes of claims.

The shapes, sizes, ratios, angles, numbers and the like disclosed in the drawings for description of various embodiments of the present disclosure to describe embodiments of the present disclosure are merely exemplary and the present disclosure is not limited thereto. Like reference numerals refer to like elements throughout. Throughout this specification, the same elements are denoted by the same reference numerals. As used herein, the terms "comprise", "having," "including" and the like suggest that other parts can be added unless the term "only" is used. As used herein, the singular forms "a", "an", and "the" are intended to include the plural forms as well, unless context clearly indicates otherwise.

In construing an element included in various embodiments of the present disclosure, the element is construed to include an error range even without separate explicit description.

In describing various embodiments of the present disclosure, in a case which describes a position relationship, for example, in a case where a position relationship between two elements is described to be 'on ~', 'over ~', 'under ~', 'next to ~', 'side ~', 'upper ~', or 'lower ~', one or more other elements may be disposed between two elements unless 'just' or 'direct' is used.

An element or a layer being "on" another element or layer may include all cases where the element or layer is just on the other element or layer, or another element or layer is therebetween.

In describing various embodiments of the present disclosure, the terms 'first ~' and 'second ~' may be used for describing various elements, but the terms are merely used for distinguishing like or similar elements from each other. Therefore, in the present disclosure, unless separately described, an element modified by 'first ~' may be the same as an element modified by 'second ~' in the technical idea of the present disclosure.

Herein, like reference numerals refer to like elements.

An area and a thickness of each element in the drawings are illustrated for convenience of description, and embodiments of the present disclosure are not limited to the illustrated area and thickness of each element.

Features of various embodiments of the present disclosure may be partially or overall coupled to or combined with each other and may be variously inter-operated with each other and driven technically as those skilled in the art can sufficiently understand. The embodiments of the present disclosure may be carried out independently of each other, or may be carried out together in co-dependent relationship.

Hereinafter, embodiments of the present disclosure will be described in detail with reference to the accompanying drawings.

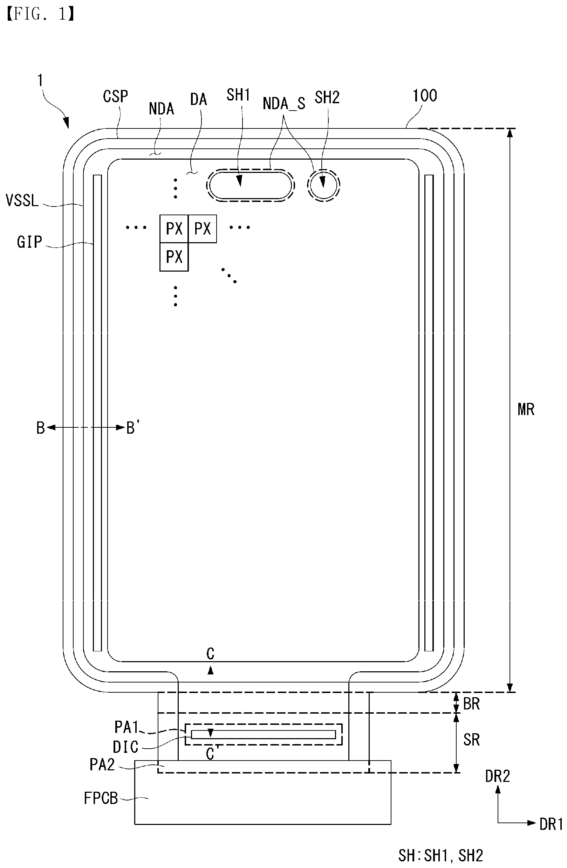

FIG. 1 is a plan view of a display apparatus 1 according to an embodiment.

Referring to FIG. 1, the display apparatus 1 according to an embodiment may include a display panel 100. The display panel 100 may include a display area DA including a plurality of pixels PX and a non-display area NDA at a periphery of the display area DA. A planar shape of the display area DA may have a rectangular shape. However, the present disclosure is not limited thereto, and the planar shape of the display area DA may have a square shape, a circular shape, an oval shape, or the other polygonal shape. For example, the display area DA may have a corner-rounded rectangular shape, but is not limited thereto and may have a corner-angled rectangular shape.

In embodiments, a first direction DR1 and a second direction DR2 may differ and may be directions intersecting each other, and for example, may denote directions perpendicular to each other in a plan view. In FIG. 1, the first direction DR1 may be substantially the same as an extension direction of each of short sides of the display panel 100, and the second direction DR2 may be substantially the same as an extension direction of each of long sides of the display panel 100. However, it should be understood that a direction described in an embodiment denotes a relative direction, and an embodiment is not limited to the described direction.

The display area DA may include short sides which extend in the first direction DR1 and long sides which extend in the second direction DR2. The non-display area NDA may surround the display area DA. The non-display area NDA may be disposed at one side and the other side of the display area DA in the first direction DR1 and one side and the other side of the display area DA in the second direction DR2.

The display panel 100 may further include a sensor non-display area NDA_S and a sensor hole SH surrounded by the sensor non-display area NDA_S. Sensor holes SH1 and SH2 may be surrounded by the display area DA in a plane. For example, the number of sensor holes may be two as in FIG. 1, but embodiments of the present disclosure are not limited thereto. For example, a sensor hole may be provided as one. Two sensor holes SH1 and SH2 may include a sensor hole where an infrared sensor is disposed and a sensor hole where a camera sensor is disposed, but embodiments of the present disclosure are not limited thereto. The sensor non-display area NDA_S may be disposed between the sensor holes SH1 and SH2 and the display area DA. The sensor non-display area NDA_S may fully surround the sensor holes SH1 and SH2. The pixel PX may not be disposed in the sensor non-display area NDA_S.

Gate drivers GIP may be respectively disposed in non-display areas NDA disposed at the one side and the other side of the display area DA in the first direction DR1. A low-level voltage line VSSL may be disposed outside the gate driver GIP in the non-display area NDA. For example, as illustrated in FIG. 1, the low-level voltage line VSSL may extend from a printed circuit board FPCB and may pass through a sub region SR and a bending region BR, and moreover, may be disposed outside the gate driver GIP in the non-display area NDA and may be disposed to surround the display area DA.

The non-display area NDA disposed at the other side of the display area DA in the second direction DR2 may further extend in a direction toward the other side in the second direction DR2 with respect to a center portion of the other side of the display area DA in the second direction DR2. With respect to the center portion of the other side of the display area DA in the second direction DR2, a first-direction (DR1) width of the non-display area NDA further extending to the other side of the display area DA in the second direction DR2 may be less than a first-direction (DR1) width of the non-display area NDA adjacent to the other side of the display area DA in the second direction DR2.

The display apparatus 1 may include a main region MR, the sub region SR, and the bending region BR between the main region MR and the sub region SR. The display area DA described above and the non-display area NDA surrounding the display area DA in four surfaces may configure the main region MR, and with respect to the center portion of the other side of the display area DA in the second direction DR2, a portion further extending to the other side of the display area DA in the second direction DR2 may configure the bending region BR and the sub region SR. The bending region BR may be disposed between the sub region SR and the main region MR. The sub region SR may include a first pad region PA1 and a second pad region PA2 disposed at the other end portion of the sub region SR in the second direction DR2. The display apparatus 1 may further include a data driver DIC and the printed circuit board FPCB. The data driver DIC may be disposed in the first pad region PA1, and the printed circuit board FPCB may be attached to the second pad region PA2. A plurality of pads connected to the data driver DIC and the printed circuit board FPCB may be respectively disposed in the first pad region PA1 and the second pad region PA2. The data driver DIC may be formed in the form of driving chip (IC) for example, but is not limited thereto. In an embodiment, a case is illustrated where the data driver DIC is disposed as a chip on plastic type where the data driver DIC is directly mounted on the display panel 100, but embodiments of the present disclosure are not limited thereto and the data driver DIC may be disposed as a chip on glass (COG) type or a chip on film (COF) type.

The display panel 100 according to an embodiment may further include a crack sensing pattern CSP which surrounds the low-level voltage line VSSL. The crack sensing pattern CSP, as illustrated in FIG. 1, may be disposed to fully surround the display area DA. For example, the crack sensing pattern CSP may be outside the low-level voltage line VSSL. However, embodiments of the present disclosure are not limited thereto, and a portion of the crack sensing pattern CSP may not be disposed in the non-display area NDA disposed at the other side of the display area DA in the second direction DR2.

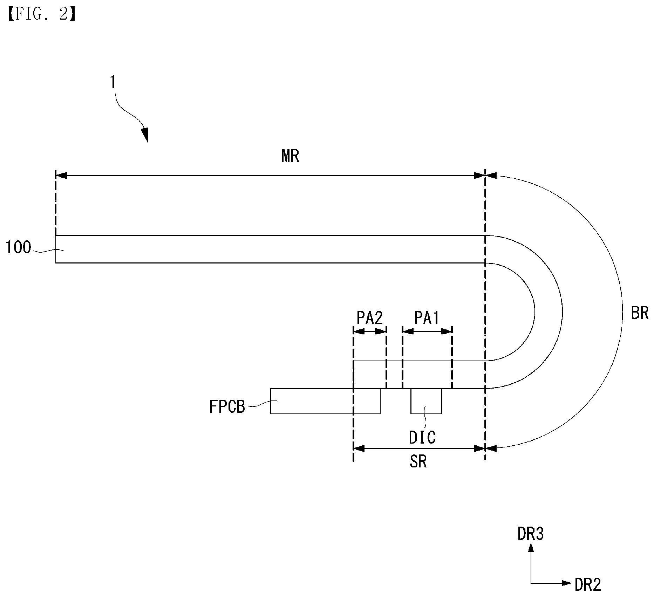

FIG. 2 is a cross-sectional view illustrating a state where the display panel illustrated in FIG. 1 is bent.

Referring to FIG. 2, the bending region BR of the display panel 100 of the display apparatus 1 according to an embodiment may be bent in a thickness direction (or a third direction DR3). Therefore, the main region MR and the sub region SR may overlap each other in the thickness direction. The display panel 100 may be bent as a type where a lower surface of the main region MR and an upper surface of the sub region SR face each other. The printed circuit board FPCB may be attached to an end portion of the sub region SR.

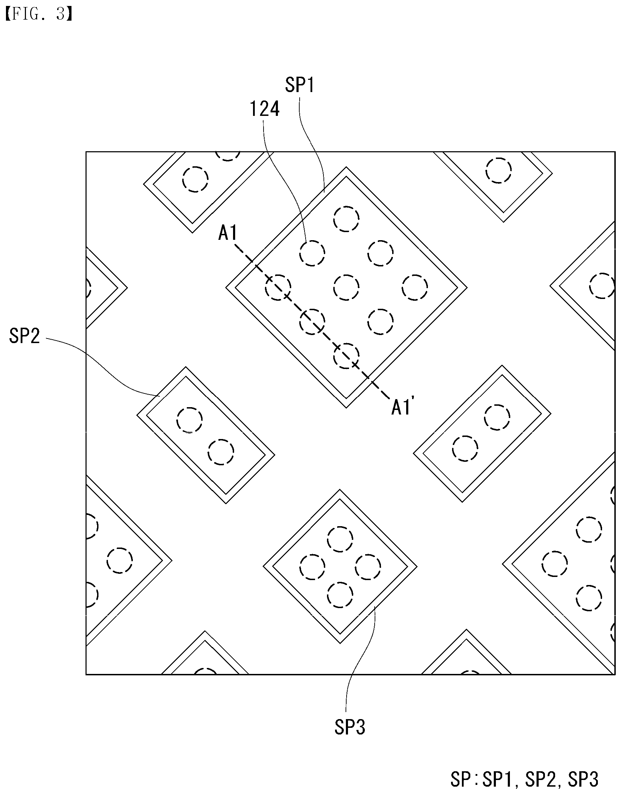

FIG. 3 is a plan arrangement view of subpixels of the display area of FIG. 1. A plurality of first to third subpixels SP1 to SP3 may be provided. Colors of lights emitted from the first to third subpixels SP1 to SP3 may differ. For example, the first subpixel SP1 may emit blue light, the second subpixel SP2 may emit green light, and the third subpixel SP3 may emit red light. However, embodiments of the present disclosure are not limited thereto.

Emission areas of the first to third subpixels SP1 to SP3 may differ. For example, the emission areas of the first subpixel SP1 and the second subpixel SP2 may differ. The emission areas of the first subpixel SP1 and the third subpixel SP3 may differ. The emission areas of the second subpixel SP2 and the third subpixel SP3 may differ.

Each of the first to third subpixels SP1 to SP3 may include a plurality of protrusion portions 124. A planar shape of the protrusion portion 124 may have a circular shape. However, embodiments of the present disclosure are not limited thereto, and a planar shape of the protrusion portion 124 may have a square shape, a circular shape, an oval shape, or the other polygonal shape. Since the protrusion portions 124 can be implemented in various shapes, a flexible configuration of the concave-convex structure can be achieved. The number of protrusion portions 124 included in the first to third subpixels SP1 to SP3 may differ. For example, the first subpixel SP1 and the second subpixel SP2 having different emission areas may include a different number of protrusion portions 124. To provide a detailed description, the first subpixel SP1 having a large emission area may include more protrusion portions 124 than the second subpixel SP2 or the third subpixel SP3. That is, the number of protrusion portions 124 may differ for each subpixel.

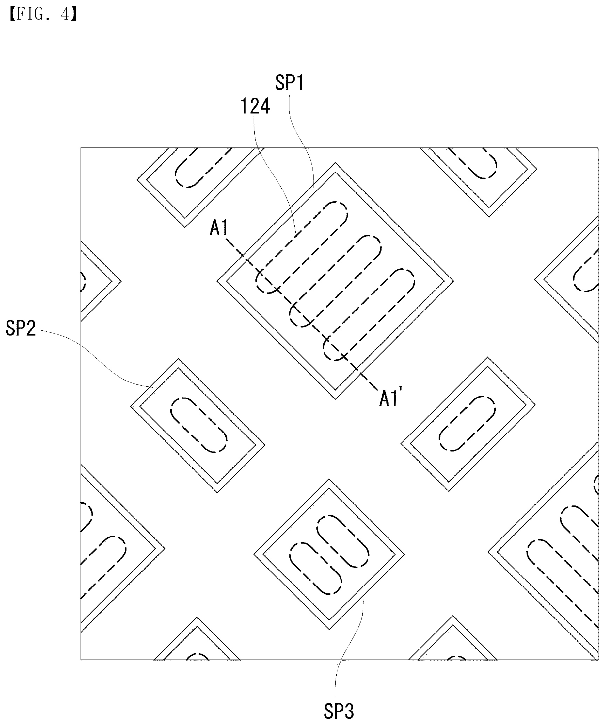

FIG. 4 is another embodiment of FIG. 3. Descriptions overlapping FIG. 3 are omitted. Referring to FIG. 4, a planar shape of the protrusion portion 124 may have a long cylindrical shape.

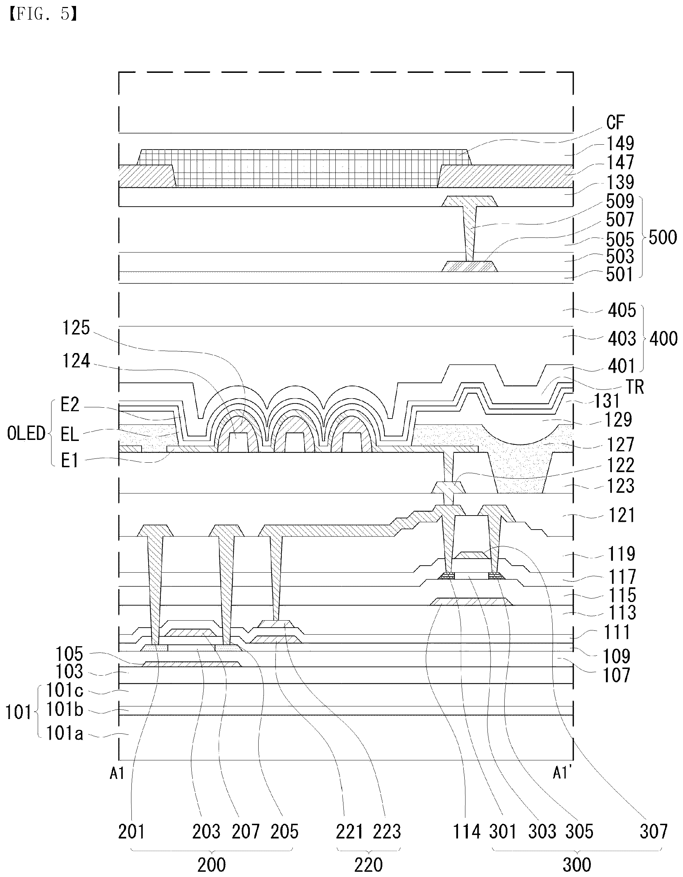

FIG. 5 is a cross-sectional view taken along line A1-A1' of FIG. 3 or FIG. 4. FIG. 5 may be a diagram illustrating only some regions and some elements disposed in one subpixel SP and may be a diagram illustrating only some regions and some elements disposed in a pad region.

Referring to FIG. 5, a pixel (see PX of FIG. 1) of the display panel 100 may include a plurality of subpixels. The subpixels may be red, green, blue, and white subpixels, but embodiments of the present disclosure are not limited thereto.

The display panel 100 may include a substrate 101, a first thin film transistor (TFT) 200, a second TFT 300, an organic light emitting device OLED, an encapsulation part 400, a touch part 500, a black matrix 147, a color filter CF, and a planarization layer 149.

The display panel 100 may include at least one panel insulation layer between the substrate 101 and the organic light emitting device OLED. The at least one panel insulation layer may include at least one of a multi buffer layer 103, a first insulation layer 107, a second insulation layer 109, a third insulation layer 111, a fourth insulation layer 113, a fifth insulation layer 115, a sixth insulation layer 117, a seventh insulation layer 119, a first organic insulation layer 121, a second organic insulation layer 123, and a third organic insulation layer 125. At least one touch insulation layer may be disposed on the organic light emitting device OLED. The at least one touch insulation layer may include at least one of a touch buffer layer 501, a first touch insulation layer 503, and a second touch insulation layer 505. Hereinafter, at least one panel insulation layer 103, 107, 109, 111, 113, 115, 117, and 119 may also be referred to as at least one panel inorganic layer.

The substrate 101 may include one or more plastic materials. For example, the substrate 101 may be a multi substrate including a plurality of plastic materials such as polyimide. For example, the substrate 101 may include a first substrate part 101a and a second substrate part 101c each including a plastic material and may include a third substrate part 101b including an inorganic insulating material between the first substrate part 101a and the second substrate part 101c, but embodiments of the present disclosure are not limited thereto.

The multi buffer layer 103 may be disposed on the substrate 101. The multi buffer layer 103 may minimize or delay the diffusion of water or oxygen penetrating into the substrate 101. The buffer layer 103 may be formed by alternately stacking silicon nitride (SiNx) and silicon oxide (SiOx) at least once, but embodiments of the present disclosure are not limited thereto.

A first light blocking layer 105 may be disposed on the multi buffer layer 103. The first light blocking layer 105 may prevent light from being irradiated onto a first semiconductor layer 203 of the first TFT 200. For example, the first semiconductor layer 203 may be disposed to overlap the first light blocking layer 105. The first light blocking layer 105 may be a single layer or a multilayer, which includes one of molybdenum (Mo), aluminum (Al), chrome (Cr), nickel (Ni), neodymium (Nd), and copper (Cu), or an alloy thereof, but embodiments of the present disclosure are not limited thereto.

The first insulation layer 107 may be disposed on the multi buffer layer 103 and the first light blocking layer 105. The first insulation layer 107 may prevent short circuit between an element of the first TFT 200 and the first light blocking layer 105. The first insulation layer 107 may include the same material as that of the multi buffer layer 103, but embodiments of the present disclosure are not limited thereto. For example, the first insulation layer 107 may include an inorganic insulating material such as SiNx or SiOx, but embodiments of the present disclosure are not limited thereto.

The first TFT 200 may be disposed on the first insulation layer 107. The first TFT 200 may include a first source electrode 201, the first semiconductor layer 203, a first drain electrode 205, and a first gate electrode 207.

The first semiconductor layer 203 may be disposed on the first insulation layer 107. The first semiconductor layer 203 may include a silicon-based semiconductor material such as amorphous silicon or polycrystalline silicon, but embodiments of the present disclosure are not limited thereto. The first semiconductor layer 203 may be formed of a metal oxide semiconductor such as indium gallium zinc oxide (IGZO). The first semiconductor layer 203 may include a channel region, a source region, and a drain region.

A polycrystalline semiconductor layer may be higher in mobility than an amorphous semiconductor layer and an oxide semiconductor layer, and thus, may be low in power consumption and good in reliability. Accordingly, a driving transistor may be configured with the polycrystalline semiconductor layer.

The second insulation layer 109 may be disposed on the first semiconductor layer 203. The second insulation layer 109 may include the same material as that of the first insulation layer 107 and may prevent short circuit between the first semiconductor layer 203 and another element of the first TFT 200.

The first gate electrode 207 may be disposed on the second insulation layer 109. The first gate electrode 207 may be disposed on the second insulation layer 109 to overlap the channel region of the first semiconductor layer 203. The first gate electrode 207 may be configured as a single layer or a multilayer, which includes Mo, Cu, titanium (Ti), Al, Cr, gold (Au), Ni, Nd, or a compound thereof, but embodiments of the present disclosure are not limited thereto. The first gate electrode 207 may be disposed along with a gate line.

The third insulation layer 111 may be disposed on the first gate electrode 207. The third insulation layer 111 may be formed by alternately stacking SiNx and SiOx at least once, but embodiments of the present disclosure are not limited thereto.

The first source electrode 201 and the first drain electrode 205 may be disposed on the third insulation layer 111.

The first source electrode 201 and the first drain electrode 205 may be electrically connected to the first semiconductor layer 203 through a contact hole. The first source electrode 201 and the first drain electrode 205 may be formed of a metal material. For example, the first source electrode 201 and the first drain electrode 205 may be configured as a single layer or a multilayer, which includes one of Mo, Al, Cr, Au, Ti, Ni, Nd, and Cu, or an alloy thereof, but embodiments of the present disclosure are not limited thereto.

The first source electrode 201 and the first drain electrode 205 may be disposed along with a data line. For example, the data line may be formed of the same material on the same layer as the first source electrode 201 and the first drain electrode 205, but embodiments of the present disclosure are not limited thereto.

A storage electrode 220 may be disposed apart from the first TFT 200. The storage electrode 220 may include a first storage electrode 221 and a second storage electrode 223.

The first storage electrode 221 may be formed of the same material on the same layer as the first gate electrode 207, but embodiments of the present disclosure are not limited thereto.

The second storage electrode 223 may be disposed on the first storage electrode 221. The second storage electrode 223 may be disposed on the third insulation layer 111, and a capacitance may be formed by using, as a dielectric, the third insulation layer 111 between the first storage electrode 221 and the second storage electrode 223. The second storage electrode 223 may include the same material as that of the first storage electrode 221, but embodiments of the present disclosure are not limited thereto.

The second TFT 300 may be disposed apart from the first TFT 200 and the storage electrode 220. The second TFT 300 may include a second source electrode 301, a second semiconductor layer 303, a second drain electrode 305, and a second gate electrode 307.

The second source electrode 301 may be formed of the same material as that of the first source electrode 201. The second drain electrode 305 may be formed of the same material as that of the first drain electrode 205.

The fourth insulation layer 113 may be disposed on the storage electrode 220. A second light blocking layer 114 may be disposed on the fourth insulation layer 113.

The second light blocking layer 114 may prevent light from traveling to the second semiconductor layer 303 similarly to the first light blocking layer 105, and thus, may extend a lifetime of the second TFT 300. For example, the second semiconductor layer 303 may be disposed to overlap the second light blocking layer 114.

The fifth insulation layer 115 may be disposed on the second light blocking layer 114. The fifth insulation layer 115 may include the same material as that of each of the first insulation layer 107, the second insulation layer 109, the third insulation layer 111, and the fourth insulation layer 113, but embodiments of the present disclosure are not limited thereto.

The second semiconductor layer 303 may be disposed on the fifth insulation layer 115. The second semiconductor layer 303 may include a source region, a drain region, and a channel region between the source region and the drain region.

The second semiconductor layer 303 may include a metal oxide semiconductor, such as IGZO, or a silicon-based semiconductor material such as amorphous silicon or polycrystalline silicon, but embodiments of the present disclosure are not limited thereto.

The sixth insulation layer 117 may be disposed on the second semiconductor layer 303. The sixth insulation layer 117 may include the same material as that of each of the first insulation layer 107, the second insulation layer 109, the third insulation layer 111, the fourth insulation layer 113, or the fifth insulation layer 115, but embodiments of the present disclosure are not limited thereto.

The second gate electrode 307 may be disposed on the sixth insulation layer 117. The second gate electrode 307 may include the same material as that of the first gate electrode 207. The second gate electrode 307 may be configured as a single layer or a multilayer, which includes Mo, Cu, Ti, Al, Cr, Au, Ni, Nd, or a compound thereof, but embodiments of the present disclosure are not limited thereto.

The seventh insulation layer 119 may be disposed on the second gate electrode 307. The seventh insulation layer 119 may include the same material as that of each of the first insulation layer 107, the second insulation layer 109, the third insulation layer 111, the fourth insulation layer 113, the fifth insulation layer 115, or the sixth insulation layer 117, but embodiments of the present disclosure are not limited thereto.

The first source electrode 201, the first drain electrode 205, the second source electrode 301, and the second drain electrode 305 may be disposed on the seventh insulation layer 119.

The second source electrode 301 and the second drain electrode 305 may include the same material as that of the first source electrode 201 and the first drain electrode 205 and may be disposed on the same layer, but embodiments of the present disclosure are not limited thereto. For example, the second source electrode 301 and the second drain electrode 305 may be configured as a single layer or a multilayer, which includes one of Mo, Al, Cr, Au, Ti, Ni, Nd, and Cu, or an alloy thereof, but embodiments of the present disclosure are not limited thereto. For example, the second source electrode 301 may be electrically connected to the second storage electrode 223. The second source electrode 301 may pass through the seventh insulation layer 119, the sixth insulation layer 117, the fifth insulation layer 115, and the fourth insulation layer 113 and may be electrically connected to the second storage electrode 223.

The first TFT 200 may be a switching transistor, and the second TFT 300 may be a driving transistor, but embodiments of the present disclosure are not limited thereto.

The first organic insulation layer 121 may be disposed on the second TFT 300. The first organic insulation layer 121 may planarize and protect an upper portion of each of the first TFT 200 and the second TFT 300. The first organic insulation layer 121 may include an organic material. For example, the first organic insulation layer 121 may be formed of an organic material including acrylic resin, epoxy resin, phenolic resin, polyamide resin, or polyimide resin, but embodiments of the present disclosure are not limited thereto.

The second organic insulation layer 123 may be disposed on the first organic insulation layer 121. The second organic insulation layer 123 may be formed of the same material as that of the first organic insulation layer 121, but embodiments of the present disclosure are not limited thereto.

The third organic insulation layer 125 may be disposed on the second organic insulation layer 123. The third organic insulation layer 125 may be formed of the same material as that of the second organic insulation layer 123 or the first organic insulation layer 121, but embodiments of the present disclosure are not limited thereto.

A fourth organic insulation layer (not shown) may be disposed on the third organic insulation layer 125, but embodiments of the present disclosure are not limited thereto.

A connection electrode 122 may be disposed between the first organic insulation layer 121 and the second organic insulation layer 123.

The connection electrode 122 may be electrically connected to the second TFT 300 and the organic light emitting device OLED. The connection electrode 122 may be configured as a single layer or a multilayer, which includes one of Mo, Al, Cr, Au, Ti, Ni, Nd, and Cu, or an alloy thereof, but embodiments of the present disclosure are not limited thereto.

The organic light emitting device OLED may be disposed on the third organic insulation layer 125 and the second organic insulation layer 123. The organic light emitting device OLED may include a first electrode E1, an emission layer EL, and a second electrode E2. The first electrode E1 may be an anode electrode, and the second electrode E2 may be a cathode electrode, but embodiments of the present disclosure are not limited thereto.

The third organic insulation layer 125 may be disposed under the first electrode E1 in a round shape such as a lens shape. For example, the third organic insulation layer 125 may have one or more protrusion elements (i.e., the following protrusion portion 124) in a concave-convex structure. As shown in FIG. 5, each of the one or more protrusion elements is covered by the third organic insulation layer 125. A cross-sectional shape of the third organic insulation layer 125 may have a semicircular shape. However, embodiments of the present disclosure are not limited thereto, and the cross-sectional shape of the third organic insulation layer 125 may be a square shape, a semi-oval shape, or the other polygonal shape. Since the third organic insulation layer 125 can be implemented in various shapes, a flexible configuration of the concave-convex structure can be achieved.

Concave-convex structures of the third organic insulation layer 125 may not be connected to each other and may be separated from each other. The first electrode E1 disposed between a plurality of third organic insulation layers 125 may contact the second organic insulation layer 123.

The protrusion portion 124 may be disposed under each concave-convex structure of the third organic insulation layer 125. The protrusion portion 124 may be disposed on a flat upper surface of the second organic insulation layer 123. The protrusion portion 124 may function as a structure which allows the third organic insulation layer 125 disposed thereon to be bent toward a front surface and have a protruding structure and may allow the organic light emitting device OLED disposed on the third organic insulation layer 125 to include a flexural concave-convex structure. Since the first electrode E1, the emission layer EL, and the second electrode E2 are covered on the third organic insulation layer 125 in the emission region, the concavo-convex structure formed by the first electrode E1, the emission layer EL, and the second electrode E2 of the organic light-emitting device OLED may correspond to the concavo-convex structure of the third organic insulation layer 125. As shown in FIG.5, the concavo-convex structure formed by the first electrode E1, the emission layer EL, and the second electrode E2 may be formed in at least a portion of the emission region. Therefore, the organic light-emitting device OLED (including the first electrode E1, the emission layer EL, and the second electrode E2) has one or more protrusions in the emission region which protrude (e.g., bend) toward the front surface (the direction opposite to the substrate 101), the one or more protrusions corresponding to the one or more protrusion portions 124 and the third organic insulation layer 125 having the protruding structure. As in FIG. 5, when the protrusion portion 124 is provided in plurality in an emission region, the plurality of protrusion portions 124 may be spaced apart from one another.

The protrusion portion 124 may be formed of a metal material. For example, the protrusion portion 124 may be configured as a single layer or a multilayer, which includes one of Mo, Al, Cr, Au, Ti, Ni, Nd, and Cu, or an alloy thereof, but embodiments of the present disclosure are not limited thereto. As the protrusion portion 124 is provided, a taper and a thickness of the third organic insulation layer 125 may be easily adjusted. For example, the taper of the third organic insulation layer 125 may be formed to be high on the protrusion portion 124. As an example, the taper of the third organic insulation layer 125 may be formed to be higher on the protrusion portion 124 than on the side surfaces of the protrusion portion 124. For example, the thickness of the third organic insulation layer 125 may be formed to be thick on the protrusion portion 124. As an example, the thickness of the third organic insulation layer 125 may be formed to be thicker on the protrusion portion 124 than on the side surfaces of the protrusion portion 124. Accordingly, a concave-convex structure of the third organic insulation layer 125 may be easily formed.

A cross-sectional shape of the protrusion portion 124 may have a rectangular shape. However, embodiments of the present disclosure are not limited thereto, and the cross-sectional shape of the protrusion portion 124 may be a square shape, a semicircular shape, a semi-oval shape, or the other polygonal shape. Since the protrusion portions 124 can be implemented in various shapes, a flexible configuration of the concave-convex structure can be achieved.

A concave-convex structure of each of the protrusion portion 124 and the third organic insulation layer 125 may allow much light to be scattered in the organic light emitting device OLED formed along a flexural surface, and thus, may improve a color viewing angle and may enhance light extraction efficiency.

The second organic insulation layer 123 may include at least one concave portion in one subpixel region. The at least one concave portion may be disposed at a portion overlapping a first bank 127 in the second organic insulation layer 123. The first organic insulation layer 121 may be exposed by at least one concave portion, and the second organic insulation layer 123 may have a step height equal to a thickness of the second organic insulation layer 123 in a portion where at least one concave portion is formed.

Therefore, the first bank 127 stacked on an upper surface of the second organic insulation layer 123 may have a step height, a length of a common layer including an emission layer EL provided on the first bank 127 may be relatively longer provided based on the step height of the first bank 127, and a lateral current flowing from one subpixel to an adjacent subpixel through the common layer may decrease. Accordingly, the at least one concave portion according to the present disclosure may decrease a lateral current flowing to an adjacent subpixel through the common layer including the emission layer EL, thereby preventing crosstalk between adjacent subpixels.

The first electrode E1 may be connected to the connection electrode 122 through a contact hole formed in the second organic insulation layer 123. Also, the first electrode E1 may be electrically connected to the second TFT 300 through the connection electrode 122. The first electrode E1 may be a reflective electrode which reflects light, but embodiments of the present disclosure are not limited thereto. The first electrode E1 may include a metal material, having a high reflectance, such as a stack structure (Ti/Al/Ti) of Al and Ti, a stack structure (ITO/Al/ITO) of Al and indium tin oxide (ITO), and an APC alloy, and may be configured as a single layer or a multilayer, but embodiments of the present disclosure are not limited thereto.

The emission layer EL may be disposed on the first electrode E1. The emission layer EL may include one or more emission structures (or light emitting devices or devices) which are stacked on the first electrode E1 in the order of a hole transfer layer and an electron transfer layer or a reverse order thereof. For example, the hole transfer layer may include a hole transport layer, a hole injection layer, an electron blocking layer, or a P-type charge generating layer, but embodiments of the present disclosure are not limited thereto. For example, the electron transfer layer may include an electron transport layer, an electron injection layer, a hole blocking layer, or an N-type charge generating layer, but embodiments of the present disclosure are not limited thereto.

The emission layer EL may be an organic emission layer, an inorganic emission layer, a quantum dot emission layer, a micro light emitting diode, or a mini light emitting diode, but embodiments of the present disclosure are not limited thereto. For example, the emission layer EL of the display panel 100 according to an embodiment of the present disclosure may include an organic emission layer. The emission layer EL may include a red emission layer, a green emission layer, and a blue emission layer. The emission layer EL may further include a white emission layer, but embodiments of the present disclosure are not limited thereto.

The second electrode E2 may be disposed on the emission layer EL. The second electrode E2 may be a transparent electrode which transmits light, but embodiments of the present disclosure are not limited thereto. For example, the second electrode E2 may include a transparent conductive material, such as ITO or indium zinc oxide (IZO), or metal which transmits visible light, but embodiments of the present disclosure are not limited thereto.

The first bank 127 may be disposed to expose the first electrode E1. The first bank 127 may define an emission region of a subpixel and may be disposed to cover an edge portion (or a border portion or a periphery portion) of the first electrode E1.

The first bank 127 may include a black-based material. For example, the first bank 127 may include a material including a black pigment or an organic material such as benzocyclobutene resin, polyimide resin, acrylic resin, or a photosensitive polymer, but embodiments of the present disclosure are not limited thereto. When the first bank 127 includes a material including a black pigment or a black dye, the first bank 127 may be a black bank. When the first bank 127 includes a material including a black pigment or a black dye, the first bank 127 may block light from the outside or may block light reflected from the outside, and thus, the luminance of the display apparatus may be improved. The first bank 127 may absorb light additionally reflected from a lower portion of the first bank 127 among lights incident from the outside.

A second bank 129 may be disposed on the first bank 127. The second bank 129 may include a transparent material. The second bank 129 may be a transparent bank, but embodiments of the present disclosure are not limited thereto.

In detail, the second bank 129 may be disposed on an upper surface or a side surface of the first bank 127. Also, the second bank 129 may be disposed in at least a portion, where the first bank 127 is not disposed, of the first electrode E1. For example, the second bank 129 may be disposed on the upper surface or the side surface of the first electrode E1 disposed in a concave portion of the third organic insulation layer 125.

A spacer 131 may be further disposed on the second bank 129. The spacer 131 may include the same material as that of the second bank 129, but embodiments of the present disclosure are not limited thereto. For example, the spacer 131 may be a transparent bank. The spacer 131 may include the same material as that of the second bank 129 and may be simultaneously formed with the second bank 129 through a halftone mask and thus formed as one body with the second band 129, but embodiments of the present disclosure are not limited thereto.

The first bank 127 and the second bank 129 may each include a trench TR. The first bank 127 may include the trench TR which is formed by passing through the second organic insulation layer 123, and the first bank 127 may fill the trench TR. The spacers 131 on the second bank 129 may be separated due to the trench TR. The emission layer EL disposed on the second bank 129 and the spacer 131 may be reduced in thickness in a trench TR region (for example, the trench TR formed by the spacer 131 and the second bank 129). A thickness-reduced emission layer EL may increase in resistance, and thus, a leakage current between adjacent subpixels may be improved. It should be noted that this reduction in thickness of the emission layer EL is not necessarily shown in all drawings.

The emission layer EL may be disposed on the first electrode E1, the first bank 127, the second bank 129, and the spacer 131. The second electrode E2 may be disposed on the emission layer EL.

The encapsulation part 400 may be disposed on the second electrode E2. The encapsulation part 400 may include one or more insulation layers. For example, the encapsulation part 400 may include a first encapsulation layer 401, a second encapsulation layer 403 on the first encapsulation layer 401, and a third encapsulation layer 405 on the second encapsulation layer 403. The encapsulation part 400 may include one or more inorganic insulation material layers and one or more organic material layers. For example, the first encapsulation layer 401 and the third encapsulation layer 405 may include an inorganic insulating material, and the second encapsulation layer 403 may include an organic material, but embodiments of the present disclosure are not limited thereto.

The touch part 500 may be disposed on the encapsulation part 400. The touch part 500 may include a touch buffer layer 501, a first touch conductive layer, a first touch insulation layer 503, a second touch insulation layer 505, and a second touch conductive layer. A third touch insulation layer may be disposed on the second touch conductive layer, but embodiments of the present disclosure are not limited thereto.

The first touch conductive layer may be disposed on the touch buffer layer 501. The first touch conductive layer may include a bridge electrode 507. The bridge electrode and the second touch conductive layer capable of including a below-described sensor electrode 509 may each be disposed between adjacent subpixels. For example, the bridge electrode 507 and the sensor electrode 509 may be disposed in a non-emission region. The bridge electrode 507 and the sensor electrode 509 may overlap the below-described black matrix 147 and the substrate 101 in a vertical direction. The black matrix 147 may cover the bridge electrode 507 and the sensor electrode 509. Accordingly, the bridge electrode 507 and the sensor electrode 509 may be prevented from being recognized from the outside.

The first touch insulation layer 503 may be disposed on the first touch conductive layer, and the second touch insulation layer 505 may be disposed on the first touch insulation layer 503. The first touch insulation layer 503 and the second touch insulation layer 505 may prevent short circuit between the first touch conductive layer and the second touch conductive layer. The first touch insulation layer 503 may be formed of SiOx, SiNx, or a multilayer thereof, but embodiments of the present disclosure are not limited thereto. The second touch insulation layer 505 may include an organic insulating material or an inorganic insulating material, but embodiments of the present disclosure are not limited thereto and the second touch insulation layer 505 may include the same material as that of the first touch insulation layer 503.

The second touch conductive layer may be disposed on the second touch insulation layer 505. The second touch conductive layer may include the sensor electrode 509.

The sensor electrode 509 may be electrically connected to the bridge electrode 507 through a contact hole formed in each of the first touch insulation layer 503 and the second touch insulation layer 505.

The sensor electrode 509 and the bridge electrode 507 may include a metal material. For example, the sensor electrode 509 and the bridge electrode 507 may include Ti, Ni, Al, or an alloy thereof and may be formed of three layers such as Ti/Al/Ti, but embodiments of the present disclosure are not limited thereto.

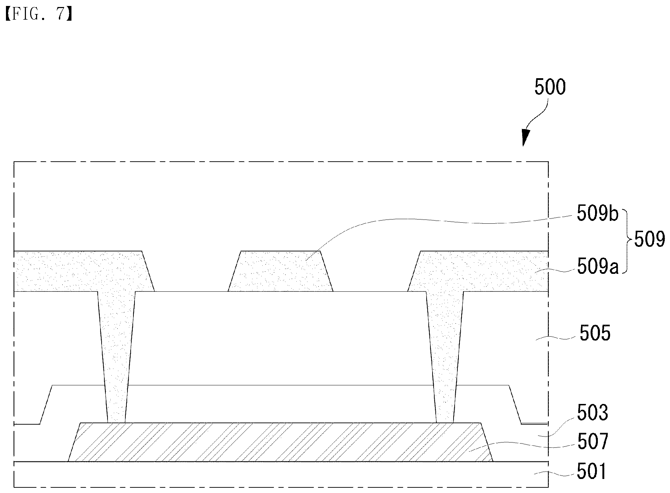

A detailed configuration of the touch part 500 will be described below with reference to FIG. 7.

The cover buffer layer 139 may be disposed on the second touch conductive layer. The cover buffer layer 139 may include an inorganic insulating material such as SiNx or SiOx, but embodiments of the present disclosure are not limited thereto.

The black matrix 147 may be disposed on the cover buffer layer 139. The black matrix 147 may include a black material. For example, the black matrix 147 may include a light blocking material or a light absorbing material. For example, the black matrix 147 may include a material such as a black pigment or a black dye. The black matrix 147 may cover the bridge electrode 507 and the sensor electrode 509. Accordingly, the bridge electrode 507 and the sensor electrode 509 may be prevented from being recognized from the outside.

The color filter CF may be disposed on the black matrix 147.

The color filter CF may be disposed in each subpixel and may block a specific color in light emitted from an emission region of each subpixel. For example, a color filter disposed in a subpixel emitting red light may be provided to block light of the other color except red light. However, embodiments of the present disclosure are not limited thereto.

The color filter CF may directly contact each of a side surface and an upper surface of the black matrix 147. For example, a plurality of color filters CF may be spaced apart from each other at a boundary between adj acent subpixels, but embodiments of the present disclosure are not limited thereto and the plurality of color filters CF may overlap the substrate in a vertical direction.

The planarization layer 149 may be disposed on the color filter CF. The planarization layer 149 may planarize a step height formed by the color filter CF. The planarization layer 149 may include an organic insulating material.

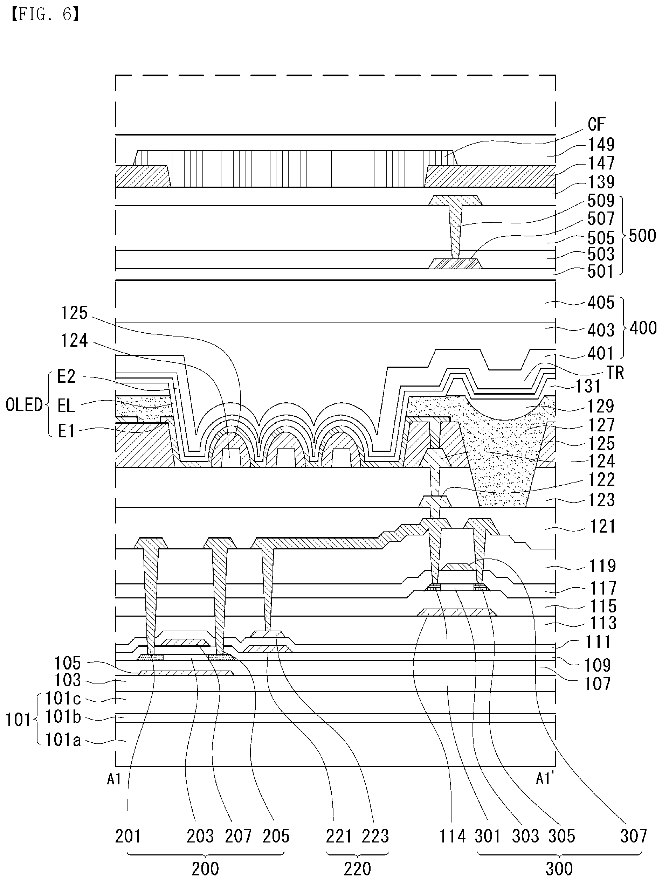

FIG. 6 is another embodiment of FIG. 5. Descriptions overlapping FIG. 5 are omitted.

Referring to FIG. 6, the third organic insulation layer 125 may be disposed on the second organic insulation layer 123. The third organic insulation layer 125 may be disposed under the first electrode E1 and under the first bank 127. The first electrode E1 may be disposed between the third organic insulation layer 125 and the first bank 127. The first electrode E1 may be disposed on an upper surface and a side surface of the third organic insulation layer 125. In detail, the first electrode E1 may be disposed in an inclined region of the third organic insulation layer 125. Accordingly, a portion of light emitted from the emission layer EL may be reflected by the first electrode E1 of the inclined region and may be extracted to the outside of the display panel 100, and thus, an effect of improving light extraction may be realized. Also, the first electrode E1 may be disposed in the inclined region and may block a portion of side light of the light emitted from the emission layer EL, and thus, an effect of preventing color mixture between adjacent subpixels may be realized.

The emission layer EL may be disposed on the first electrode E1. The second electrode E2 may be disposed on the emission layer EL. The first electrode E1 may be electrically connected to the second TFT 300 through the protrusion portion 124 (for example, a second protrusion portion 124) and the connection electrode 122. The protrusion portion 124 may pass through the second organic insulation layer 123 and may thus allow a contact hole to be formed. The connection electrode 122 may pass through the first organic insulation layer 121 and may thus allow a contact hole to be formed. Since the second protrusion portion 124 may be formed through the same process as the protruding portion 124 disposed under each concave-convex structure described above, thereby preventing a decrease in process efficiency.

FIG. 7 is a cross-sectional view of a touch part illustrated in FIGs. 5 and 6. Descriptions overlapping FIG. 5 are omitted.

Referring to FIG. 7, the second touch conductive layer may be disposed on the second touch insulation layer 505. The second touch conductive layer may include a first sensor electrode 509a and a second sensor electrode 509b. The sensor electrode 509 may include the first sensor electrode 509a extending in a first direction (see DR1 of FIG. 1) and the second sensor electrode 509b extending in a second direction (see DR2 of FIG. 1) perpendicular to the first direction DR1.

The bridge electrode 507 may be electrically connected to the first sensor electrode 509a through a contact hole formed in each of the first touch insulation layer 503 and the second touch insulation layer 505. For example, the first sensor electrode 509a and the bridge electrode 507 may extend in the first direction (see DR1 of FIG. 1).

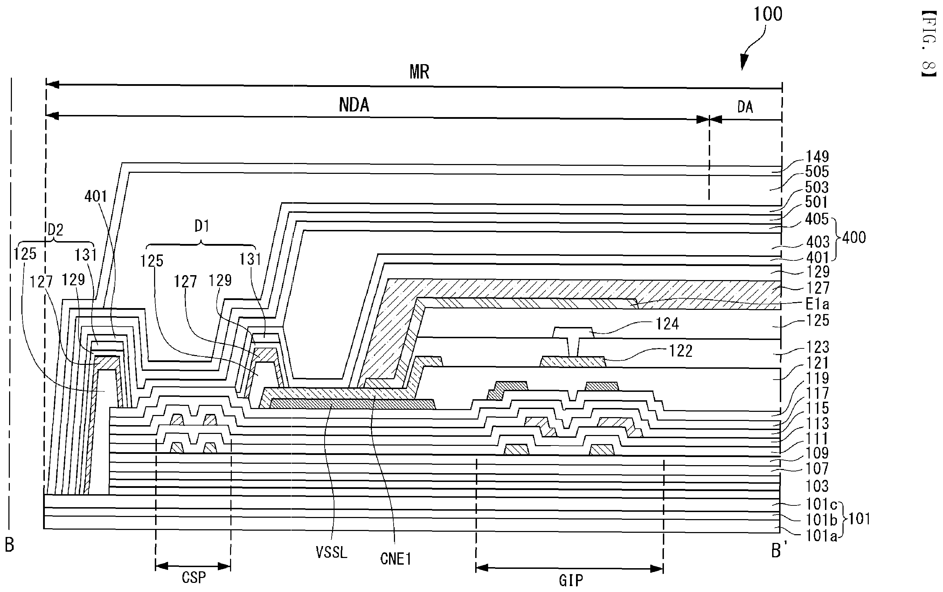

FIG. 8 is a cross-sectional view taken along line B-B' of FIG. 1.

Referring to FIG. 8, at least one panel inorganic layers 103, 107, 109, 111, 113, 115, 117, and 119 may not extend up to an end portion of the substrate 101. That is, the at least one panel inorganic layers 103, 107, 109, 111, 113, 115, 117, and 119 may expose the end portion of the substrate 101, but embodiments of the present disclosure are not limited thereto.

The display panel 100 according to an embodiment may further include the crack sensing pattern CSP, the low-level voltage line VSSL, and the gate driver GIP. As described above with reference to FIG. 1, the low-level voltage line VSSL may be disposed between the crack sensing pattern CSP and the display area DA, and the gate driver GIP may be disposed between the low-level voltage line VSSL and the display area DA.

For example, as illustrated in FIG. 8, the gate driver GIP may be configured with a conductive layer disposed on the same layer as the first gate electrode (see 207 of FIG. 5), a conductive layer disposed on the same layer as the second light blocking layer (see 114 of FIG. 5), or a conductive layer disposed on the same layer as the first source electrode 201, but embodiments of the present disclosure are not limited thereto.

For example, the crack sensing pattern CSP may be disposed between a first dam D1 and a second dam D2. The crack sensing pattern CSP may be configured with a conductive layer disposed on the same layer as the first gate electrode (see 207 of FIG. 5) or a conductive layer disposed on the same layer as the second light blocking layer (see 114 of FIG. 5), but embodiments of the present disclosure are not limited thereto. For example, the crack sensing pattern CSP may include a conductive layer disposed on the same layer as the first source electrode 201, but embodiments of the present disclosure are not limited thereto.

The low-level voltage line VSSL may be disposed between the crack sensing pattern CSP and the gate driver GIP. The low-level voltage line VSSL may be configured as a conductive layer disposed on the same layer as the first source electrode 201, but embodiments of the present disclosure are not limited thereto.

The first organic insulation layer 121 may cover the gate driver GIP, cover a portion of one end portion of the low-level voltage line VSSL, and expose another portion of the low-level voltage line VSSL. Herein, one end portion may denote a region of an arbitrary element disposed closer to the display area DA in a direction toward the display area DA from the non-display area NDA, and the other end portion may denote a region of an arbitrary element disposed closer to the non-display area NDA in a direction toward the non-display area NDA from the display area DA.

A connection electrode CNE1 disposed on the same layer as the connection electrode 122 may be disposed on the first organic insulation layer 121. The first connection electrode CNE1 may be directly connected to a region of the low-level voltage line VSSL exposed by the first organic insulation layer 121. The first connection electrode CNE1 may cover the other end portion of the low-level voltage line VSSL, but embodiments of the present disclosure are not limited thereto.

The second organic insulation layer 123 may be disposed on the first connection electrode CNE1. The second organic insulation layer 123 may directly contact and cover one end portion of the first connection electrode CNE1 and may expose another portion of the first connection electrode CNE1.

The third organic insulation layer 125 may be disposed on the second organic insulation layer 123.

The third organic insulation layer 125 may configure a first layer of the first dam D1 and a first layer of the second dam D2. The first dam D1, for example, may overlap the low-level voltage line VSSL and may cover the other end portion of the low-level voltage line VSSL. The first dam D1 may directly contact the first connection electrode CNE1 and may cover the other end portion of the first connection electrode CNE1. The third organic insulation layer 125 configuring the first layer of the second dam D2 may directly contact exposed side surfaces of the at least one panel inorganic layers 103, 107, 109, 111, 113, 115, 117, and 119 and may directly contact an upper surface of the substrate 101, but embodiments of the present disclosure are not limited thereto. The third organic insulation layer 125 may overlap the gate driver GIP. Herein, it is illustrated that a dam is provided as two, but embodiments of the present disclosure are not limited thereto and the dam may be provided as three or more, or may be provided as one.

The protrusion portion 124 may be disposed on the second organic insulation layer 123. The protrusion portion 124 may use to be a signal line in the gate driver GIP in the non-display area NDA. For example, the protrusion portion 124 may use to be a transistor power supply voltage (VGL and VGH) or clock (CLK) signal line.

That is, at least one signal line included in the gate driver GIP in the non-display area NDA has the same material as that of the protrusion portion 124 (for example, a third protrusion portion 124), and at least one signal line may be provided on the second organic insulation layer 123 on which the protrusion portion 124 in the display area DA is disposed. As shown in FIG. 8, for example, the third protrusion portion 124 may be connected to the connection electrode 122 through the contact hole in the second organic insulation layer 123. Since the third protrusion portion 124 may be formed through the same process as the protruding portion 124 disposed under each concave-convex structure described above and/or the second protruding portion 124 described above, thereby preventing a decrease in process efficiency.

A low-level connection electrode E1a disposed on the same layer as the first electrode (see E1 of FIG. 5) may be disposed on the third organic insulation layer 125 and the first connection electrode CNE1 exposed by the third organic insulation layer 125. The low-level connection electrode E1a may be electrically connected to the first connection electrode CNE1 exposed by the third organic insulation layer 125. The low-level connection electrode E1a may be electrically connected to the second electrode (see E2 of FIG. 5) described above with reference to FIG. 5.

The first bank 127 and the second bank 129 may be disposed on the low-level connection electrode E1a and the third organic insulation layer 125. The first bank 127 and the second bank 129 may overlap the gate driver GIP, overlap the low-level connection electrode E1a, and overlap the other end portion of the low-level connection electrode E1a. The first bank 127 and the second bank 129 may fully cover the low-level connection electrode E1a, but embodiments of the present disclosure are not limited thereto. The first bank 127 and the second bank 129 may expose a center portion and the other end portion of the first connection electrode CNE1, but embodiments of the present disclosure are not limited thereto. The first bank 127 may configure a second layer of the first dam D1 and a second layer of the second dam D2. In each of the first and second dams D1 and D2, the first bank 127 may overlap the third organic insulation layer 125 and may fully cover the third organic insulation layer 125, but embodiments of the present disclosure are not limited thereto. In the second dam D2, the first bank 127 may contact a side surface of the third organic insulation layer 125 and may contact the upper surface of the substrate 101, but embodiments of the present disclosure are not limited thereto. The second bank 129 may configure a third layer of each of the first and second dams D1 and D2. The second bank 129 configuring the third layer of each of the first and second dams D1 and D2 may overlap the first bank 127 configuring the second layer and may fully cover the first bank 127, but embodiments of the present disclosure are not limited thereto. In the second dam D2, the second bank 129 may contact a side surface of the first bank 127 and may contact the upper surface of the substrate 101, but embodiments of the present disclosure are not limited thereto.

The spacer 131 may configure a fourth layer of the first dam D1 and a fourth layer of the second dam D2. In each of the first and second dams D1 and D2, the spacer 131 may overlap the second bank 129 configuring the third layer. In the second dam D2, the spacer 131 may overlap the second bank 129 configuring the third layer.

The encapsulation part 400 may be disposed on the spacer 131. The first encapsulation layer 401 may extend up to the gate driver GIP, the low-level voltage line VSSL, the first dam D1, and the second dam D2 and may cover an outer surface of the second dam D2. The second encapsulation layer 403 may stop at the first dam D1. The second encapsulation layer 403 may overlap the gate driver GIP and the low-level voltage line VSSL. The third encapsulation layer 405 may extend up to the gate driver GIP, the low-level voltage line VSSL, the first dam D1, and the second dam D2 and may directly contact the first encapsulation layer 401, on the first dam D1, the crack sensing pattern CSP, and the second dam D2.

The touch buffer layer 501 and the first touch insulation layer 503 may extend up to the gate driver GIP, the low-level voltage line VSSL, the first dam D1, and the second dam D2 and may cover the outer surface of the second dam D2. The second touch insulation layer 505 may extend up to the gate driver GIP, the low-level voltage line VSSL, the first dam D1, and the crack sensing pattern CSP and may stop on the second dam D2, but embodiments of the present disclosure are not limited thereto.

The cover buffer layer 139 may extend up to the gate driver GIP, the low-level voltage line VSSL, the first dam D1, and the second dam D2 and may directly contact an outer surface of the second touch insulation layer 505, but embodiments of the present disclosure are not limited thereto.

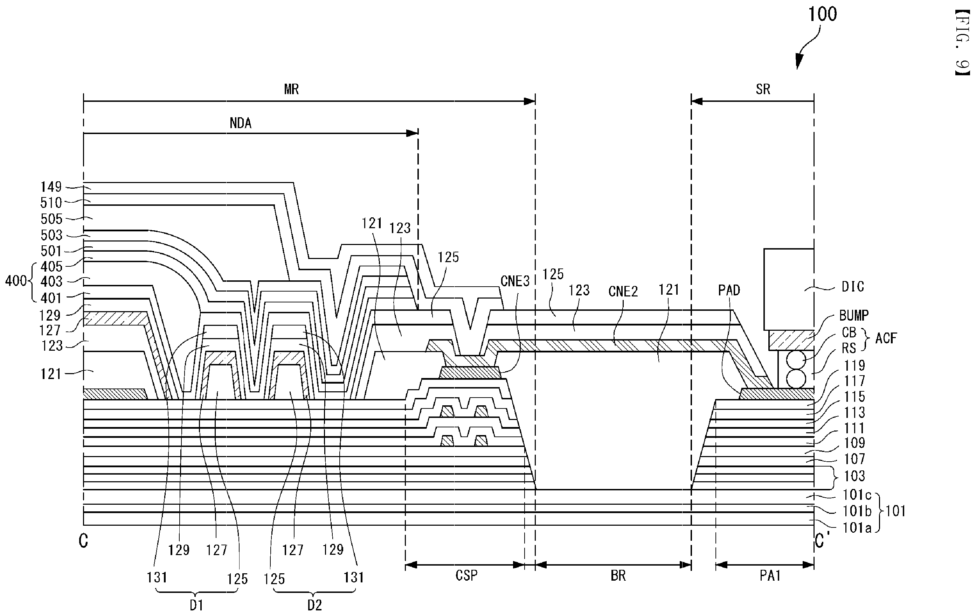

FIG. 9 is a cross-sectional view taken along line C-C' of FIG. 1.

Referring to FIGs. 5, 8, and 9, the bending region BR may be disposed between the sub region SR and the crack sensing pattern CSP. In the bending region BR, the panel inorganic layers 103, 107, 109, 111, 113, 115, 117, and 119 may be removed, and thus, the upper surface of the substrate 101 may be exposed.

A pad electrode PAD disposed on the same layer as the first source electrode (see 201 of FIG. 5) may be disposed in the first pad region PA1, and the third connection electrode CNE3 disposed on the same layer as the first source electrode (see 201 of FIG. 5) may be disposed on the crack sensing pattern CSP.

The first organic insulation layer 121 may be disposed on the pad electrode PAD and the third connection electrode CNE3. The first organic insulation layer 121 may be disposed in the bending region BR, the first organic insulation layer 121 may directly contact the upper surface of the substrate 101, and in the bending region BR, the first organic insulation layer 121 may directly contact side surfaces of the panel inorganic layers 103, 107, 109, 111, 113, 115, 117, and 119.

The second connection electrode CNE2 may be disposed on the first organic insulation layer 121 and may be disposed on the same layer as the connection electrode (see 122 of FIG. 5). The second connection electrode CNE2 may be electrically connected to the pad electrode PAD and the third connection electrode CNE3. The second connection electrode CNE2 may be disposed in the bending region BR and may also be disposed in the first pad region PA1 and on the crack sensing pattern CSP.

The data driver DIC may be disposed on the pad electrode PAD. The data driver DIC may include a bump BUMP, and an anisotropic conductive film ACF may be disposed between the pad electrode PAD and the bump BUMP and may electrically connect the pad electrode PAD to the bump BUMP. The anisotropic conductive film ACF may include a resin RS and a plurality of conductive balls CB dispersed in the resin RS. The pad electrode PAD and the bump BUMP may be electrically connected to each other through the conductive ball CB.

The second organic insulation layer 123 may be disposed on the second connection electrode CNE2. The second organic insulation layer 123 may expose the pad electrode PAD.

The third organic insulation layer 125 may be disposed on the second organic insulation layer 123. The third organic insulation layer 125 may expose the pad electrode PAD.

The first and third encapsulation layers 401 and 405 of the encapsulation part 400 may extend up to before the bending region BR. For example, the first and third encapsulation layers 401 and 405 may extend up to before the crack sensing pattern CSP, but embodiments of the present disclosure are not limited thereto and the first and third encapsulation layers 401 and 405 may overlap the crack sensing pattern CSP. The first and third encapsulation layers 401 and 405 may not be disposed in the bending region BR.

The touch buffer layer 501 and the first touch insulation layer 503 may extend up to before the bending region BR. For example, the touch buffer layer 501 and the first touch insulation layer 503 may extend up to before the crack sensing pattern CSP, but embodiments of the present disclosure are not limited thereto and the touch buffer layer 501 and the first touch insulation layer 503 may overlap the crack sensing pattern CSP. The touch buffer layer 501 and the first touch insulation layer 503 may not be disposed in the bending region BR.

The second touch insulation layer 505 may overlap the first dam D1 and the second dam D2. The second touch insulation layer 505 may not be disposed outside the second dam D2, but embodiments of the present disclosure are not limited thereto.

The touch connection line 510 may be electrically connected to the second connection electrode CNE2. The touch connection line 510 may provide a signal, applied from the pad electrode PAD and the second connection electrode CNE2, to the first sensor electrode 509a or the second sensor electrode 509b described above with reference to FIG. 7. The touch connection line 510 may be disposed on the same layer as the second touch conductive layer (the first sensor electrode 509a of FIG. 7), but embodiments of the present disclosure are not limited thereto and the touch connection line 510 may be disposed on the same layer as the first touch conductive layer (the bridge electrode 507 of FIG. 7), or the touch connection line 510 may be provided as two. For example, a first touch connection line and a second touch connection line may be provided on the same layer as the first touch conductive layer and the second touch conductive layer, respectively. However, embodiments of the present disclosure are not limited thereto.

The planarization layer 149 may be disposed on the touch connection line 510, and the planarization layer 149 may not be disposed in the bending region BR.

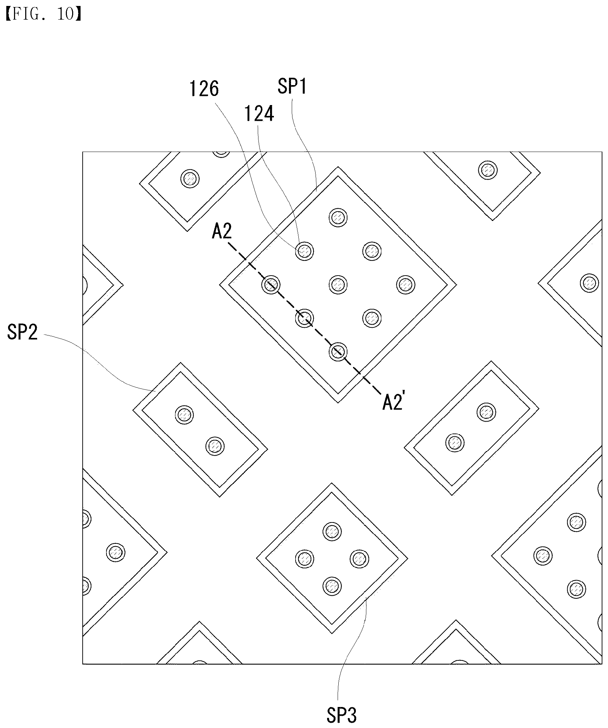

FIG. 10 is another embodiment of FIG. 3. Descriptions overlapping FIG. 3 are omitted.

Referring to FIG. 10, each of first to third subpixels SP1 to SP3 may include a plurality of protrusion portions 124. An auxiliary protrusion portion 126 may be further provided to overlap the protrusion portion 124. As illustrated, the auxiliary protrusion portion 126 may be disposed to overlap each protrusion portion 124 and may enhance a light scattering characteristic of an emission region. As illustrated, a width of the auxiliary protrusion portion 126 in a plane direction B-B' may be less than that of the protrusion portion 124 in a plane direction B-B'.

The auxiliary protrusion portion 126 may be formed of the same material as that of the third organic insulation layer 125, but embodiments of the present disclosure are not limited thereto.

A planar shape of the protrusion portion 124 may have a circular shape. However, embodiments of the present disclosure are not limited thereto, and a planar shape of the protrusion portion 124 may have a square shape, a circular shape, an oval shape, or the other polygonal shape. The number of protrusion portions 124 included in the first to third subpixels SP1 to SP3 may differ. For example, the first subpixel SP1 and the second subpixel SP2 having different emission areas may include a different number of protrusion portions 124. To provide a detailed description, the first subpixel SP1 having a large emission area may include more protrusion portions 124 than the second subpixel SP2 or the third subpixel SP3. That is, the number of protrusion portions 124 may differ for each subpixel.

A planar shape of the auxiliary protrusion portion 126 may have a circular shape. However, embodiments of the present disclosure are not limited thereto, and a planar shape of the auxiliary protrusion portion 126 may have a square shape, a circular shape, an oval shape, or the other polygonal shape. Since the auxiliary protrusion portion 126 can be implemented in various shapes, a flexible configuration of the concave-convex structure can be achieved. The number of auxiliary protrusion portions 126 included in the first to third subpixels SP1 to SP3 may differ. For example, the first subpixel SP1 and the second subpixel SP2 having different emission areas may include a different number of auxiliary protrusion portions 126. To provide a detailed description, the first subpixel SP1 having a large emission area may include more auxiliary protrusion portions 126 than the second subpixel SP2 or the third subpixel SP3. That is, the number of auxiliary protrusion portions 126 may differ for each subpixel.

The number of protrusion portions 124 may be the same as the number of auxiliary protrusion portions 126, in one subpixel, but embodiments of the present disclosure are not limited thereto.

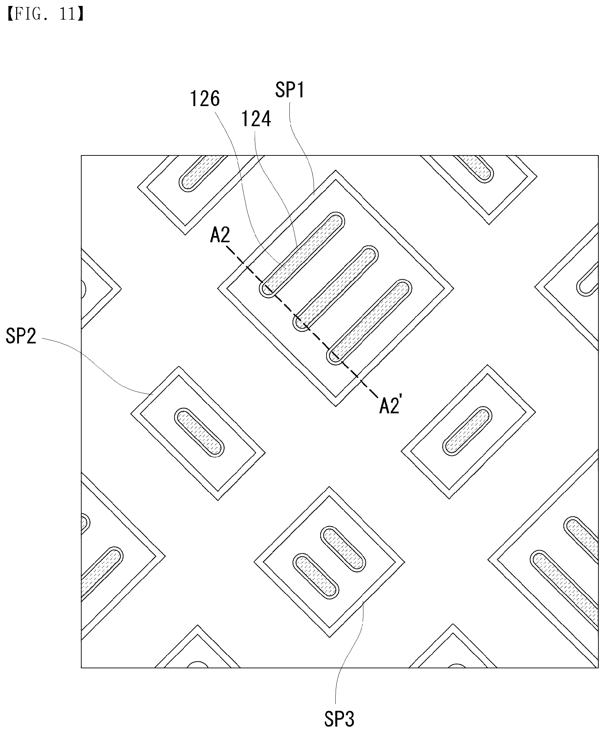

FIG. 11 is another embodiment of FIG. 10. Descriptions overlapping FIG. 10 are omitted.

Referring to FIG. 11, a planar shape of a protrusion portion 124 and an auxiliary protrusion portion 126 may each have a long cylindrical shape.

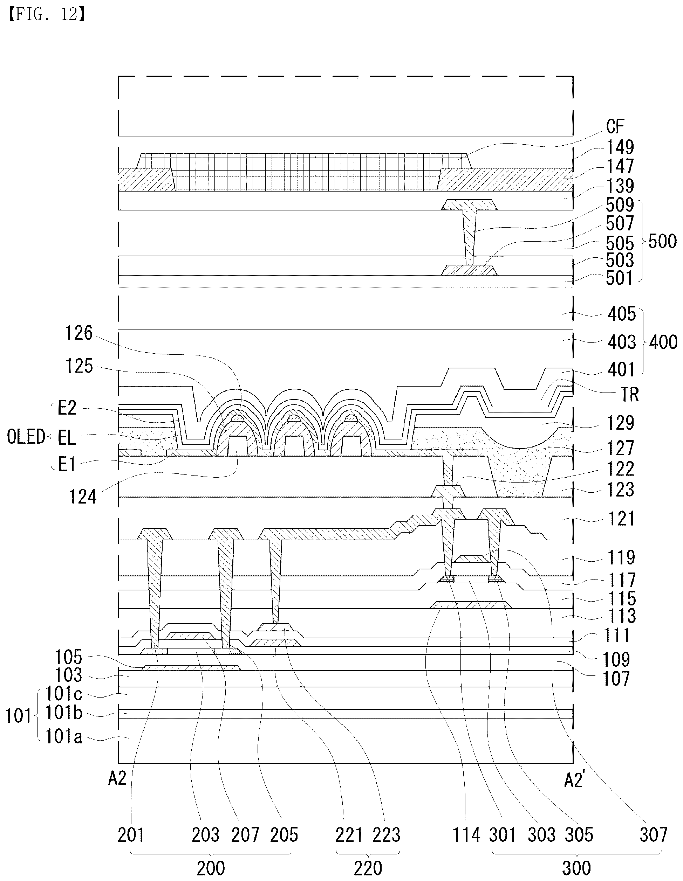

FIG. 12 is a cross-sectional view taken along line A2-A2' of FIG. 10 or FIG. 11. Descriptions overlapping FIG. 5 are omitted.

Referring to FIG. 12, an auxiliary protrusion portion 126 may be disposed on a third organic insulation layer 125. The auxiliary protrusion portion 126 may be disposed to overlap each protrusion portion 124 and may be disposed between the third organic insulation layer 125 and a first electrode E1, and a curvature radius of the auxiliary protrusion portion 126 in a thickness direction thereof may be less than a curvature radius of the third organic insulation layer 125 in a thickness direction thereof. As described above, the curvature radius of the auxiliary protrusion portion 126 in the thickness direction thereof may be set to be relatively small, and thus, an organic light emitting device OLED may be provided in a flexural concave-convex structure, thereby more enhancing a light scattering characteristic of an emission region.

A cross-sectional shape of the auxiliary protrusion portion 126 may be a semicircular shape. However, embodiments of the present disclosure are not limited thereto, and the cross-sectional shape of the auxiliary protrusion portion 126 may be a square shape, a rectangular shape, a semi-oval shape, or the other polygonal shape. Since the auxiliary protrusion portion 126 can be implemented in various shapes, a flexible configuration of the concave-convex structure can be achieved. The auxiliary protrusion portion 126 may have an area which is less than that of each of the protrusion portion 124 and the third organic insulation layer 125 which correspond to the auxiliary protrusion portion 126.

Much light may be scattered in the organic light emitting device OLED formed along a flexural surface of each of the protrusion portion 124 and the third organic insulation layer 125, and thus, may improve a color viewing angle and may enhance light extraction efficiency. Comparing with FIG. 5, the auxiliary protrusion portion 126 may be additionally configured and may include an additional flexural surface. Accordingly, a color viewing angle and light extraction efficiency may be better than FIG. 5.

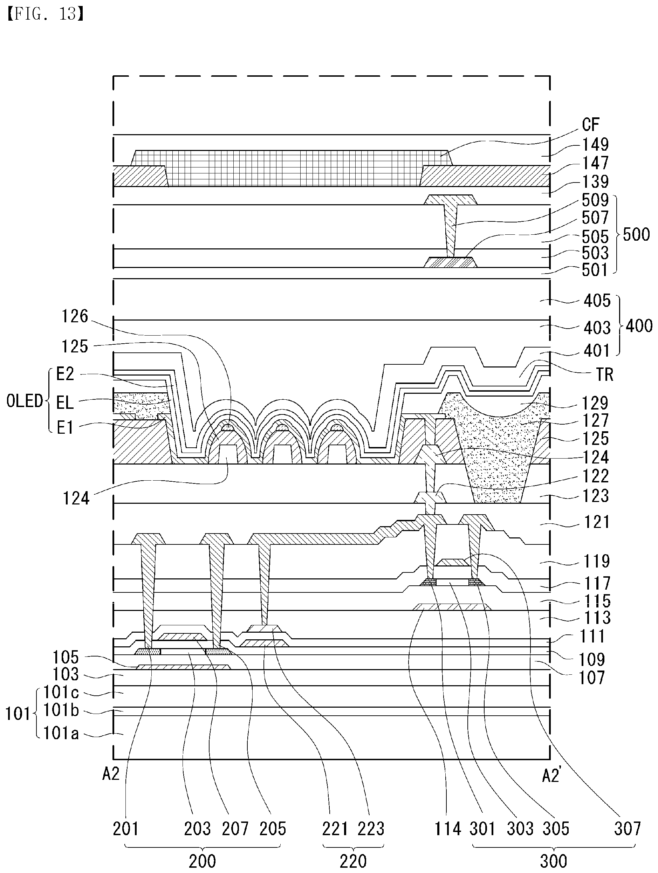

FIG. 13 is another embodiment of FIG. 12. Descriptions overlapping FIGs. 5, 6, and 12 are omitted.

Referring to FIG. 13, an auxiliary protrusion portion 126 may be disposed on a third organic insulation layer 125. A cross-sectional shape of the auxiliary protrusion portion 126 may be a semicircular shape. However, embodiments of the present disclosure are not limited thereto, and the cross-sectional shape of the auxiliary protrusion portion 126 may be a square shape, a rectangular shape, a semi-oval shape, or the other polygonal shape. The auxiliary protrusion portion 126 may have an area which is less than that of each of a protrusion portion 124 and the third organic insulation layer 125 which correspond to the auxiliary protrusion portion 126.

Much light may be scattered in an organic light emitting device OLED formed along a flexural surface of each of the auxiliary protrusion portion 126 and the third organic insulation layer 125, and thus, may improve a color viewing angle and may enhance light extraction efficiency. Comparing with FIG. 6, the auxiliary protrusion portion 126 may be additionally configured and may include an additional flexural surface. Accordingly, a color viewing angle and light extraction efficiency may be better than FIG. 6.

The present disclosure is not limited to the above embodiments. For example, a concavo-convex structure may be provided in a portion of the emission region, while a concavo-convex structure may not be provided in another portion. For example, under some protrusions of the organic light-emitting device OLED, a protrusion structure including only the third organic insulation layer 125 may be provided, instead of both the third organic insulation layer 125 and the protrusion portion 124. In this case, the protrusion structure of the third organic insulation layer 125 may be formed separately without the aid of the protrusion portion 124. For example, an auxiliary protrusion portion 126 may be provided above the protrusion structure of some third organic insulation layers 125, while no auxiliary protrusion portion 126 may be provided above the protrusion structure of some third organic insulation layers 125. For example, the size (e.g., cross-sectional area and plane area) and shape (e.g., cross-sectional shape and plane shape) of the protrusion structure of the third organic insulation layer 125 or the auxiliary protrusion portion 126 may be at least partially different from each other.

Embodiments of the present disclosure may provide a display apparatus in which a color viewing angle may be improved, and light extraction efficiency may be enhanced.

Embodiments of the present disclosure may provide a display apparatus in which a protrusion portion may be configured under an organic light emitting device, and thus, a concave-convex structure of an organic insulation layer may be easily formed.

Embodiments of the present disclosure may provide a display apparatus having a structure which may prevent color mixture between adjacent subpixels.

Embodiments of the present disclosure may provide a low-power display apparatus.

A display apparatus according to various aspects and some embodiments of the present disclosure may be described as follows.

One aspect of the present disclosure provides a display apparatus having a display area and a non-display area surrounding the display area and comprising: a substrate; a first thin film transistor and a second thin film transistor disposed on the substrate; a light emitting device disposed on the first thin film transistor and the second thin film transistor and comprising a first electrode, an emission layer and a second electrode; and an encapsulation layer disposed on the light emitting device, wherein the first electrode, the emission layer and the second electrode are formed to have a concave-convex structure in at least a portion of an emission region.

According to some embodiments of the present disclosure, the display apparatus further comprises a first insulation layer disposed under the first electrode, the first insulation layer having a concave-convex structure corresponding to the concave-convex structure.

According to some embodiments of the present disclosure, the display apparatus further comprises one or more protrusion portions disposed under the concave-convex structure of the first insulation layer.

According to some embodiments of the present disclosure, a taper of the first insulation layer is formed to be high on the one or more protrusion portions, and/or a thickness of the first insulation layer is formed to be thick on the one or more protrusion portions.

According to some embodiments of the present disclosure, the display apparatus further comprises an auxiliary protrusion portion, the auxiliary protrusion portion being disposed on the first insulation layer and under the first electrode in the emission region, and overlapping the one or more protrusion portions.

According to some embodiments of the present disclosure, a curvature radius of the auxiliary protrusion portion in a thickness direction thereof is less than a curvature radius of the first insulation layer in a thickness direction thereof.

According to some embodiments of the present disclosure, the one or more protrusion portions, the first insulation layer and the first electrode are disposed on a second insulation layer, and the display apparatus further comprises a first bank defining the emission region, the first bank being disposed to cover an edge portion of the first electrode and having a step height relative to the second insulation layer, wherein the emission layer is disposed on the first electrode and the first bank.

According to some embodiments of the present disclosure, the display apparatus further comprises: a second bank disposed on the first bank; and spacers disposed on the second bank, wherein the emission layer is disposed on the first electrode, the first bank, the second bank and the spacers, and is disposed in a trench formed by the spacers and the second bank.

According to some embodiments of the present disclosure, the first bank is a black bank and the second bank is a transparent bank.

According to some embodiments of the present disclosure, the first insulation layer is disposed under the first electrode and the first bank in a non-emission region and further includes an inclined region, and the first electrode is disposed in the inclined region of the first insulation layer.

According to some embodiments of the present disclosure, the display apparatus further comprises: a connection electrode which is disposed between the second insulation layer and a third insulation layer below the second insulation layer.

According to some embodiments of the present disclosure, the display apparatus further comprises: a second protrusion portion disposed under the first insulation layer and on the second insulation layer in a non-emission region and passing through the second insulation layer, wherein the first electrode and the second thin film transistor are electrically connected though the second protrusion portion and the connection electrode.

According to some embodiments of the present disclosure, the display apparatus further comprises: a third protrusion portion disposed in a non-display area of the display apparatus and used as a signal line, the third protrusion portion being provided on a same layer as the one or more protrusion portions and having a same material as the one or more protrusion portions, and being connected to the connection electrode.

According to some embodiments of the present disclosure, subpixels in the display apparatus have different emission areas, and a subpixel having a larger emission area comprises more of the one or more protrusion portions.

According to some embodiments of the present disclosure, a planar shape of the one or more protrusion portions is a square shape, a circular shape, an oval shape, a cylindrical shape or other polygonal shapes, and/or a cross-sectional shape of the one or more protrusion portions is a rectangular shape, a square shape, a semicircular shape, a semi-oval shape or other polygonal shapes.

According to some embodiments of the present disclosure, a cross-sectional shape of the first insulation layer is a semicircular shape, a square shape, a semi-oval shape or other polygonal shapes.

According to some embodiments of the present disclosure, a planar shape of the auxiliary protrusion portion is a square shape, a circular shape, an oval shape, a cylindrical shape or other polygonal shapes, and/or a cross-sectional shape of the auxiliary protrusion portion is a rectangular shape, a square shape, a semicircular shape, a semi-oval shape or other polygonal shapes.

According to some embodiments of the present disclosure, the display apparatus further comprises: a touch part disposed on the encapsulation layer and a color filter disposed on the touch part.

One aspect of the present disclosure provides a display apparatus having a display area and a non-display area surrounding the display area and comprising: a substrate; a first thin film transistor and a second thin film transistor disposed on the substrate; a light emitting device disposed on the first thin film transistor and the second thin film transistor and comprising a first electrode, an emission layer and a second electrode; and an encapsulation layer disposed on the light emitting device, wherein the first electrode, the emission layer, and the second electrode are formed to have one or more protrusions protruding toward a front surface of the display apparatus opposite to the substrate in at least a portion of an emission region.

According to some embodiments of the present disclosure, a protruding structure formed by a first insulation layer and a protrusion element covered by the first insulation layer are disposed under each protrusion of the one or more protrusions.

According to some embodiments of the present disclosure, when a plurality of the protrusions is provided in the emission region, a plurality of the protruding structures are separated from each other, and a plurality of the protrusion elements are spaced apart from one another.

According to some embodiments of the present disclosure, the display apparatus further comprises an auxiliary protrusion portion, the auxiliary protrusion portion being disposed on the first insulation layer and under the first electrode in the emission region, and overlapping the protrusion element.

According to some embodiments of the present disclosure, an area of the auxiliary protrusion portion is less than an area of each of the protruding structure and the protrusion element.

According to some embodiments of the present disclosure, the first insulation layer is disposed under the first electrode in a non-emission region and further includes an inclined region, and the first electrode is disposed in the inclined region of the first insulation layer.

According to some embodiments of the present disclosure, the display apparatus further comprises: a connection electrode which is disposed between a second insulation layer on which the protrusion element is formed, and a third insulation layer below the second insulation layer.

According to some embodiments of the present disclosure, the display apparatus further comprises: a third protrusion portion disposed in the non-display area of the display apparatus and used as a signal line, the third protrusion portion being provided on a same layer as the protrusion element and having a same material as the protrusion element, and being connected to the connection electrode.

According to some embodiments of the present disclosure, the display apparatus further comprises: a touch part disposed on the encapsulation layer and a color filter disposed on the touch part.

## Claims

1. A display apparatus having a display area and a non-display area surrounding the display area, comprising:
a substrate (101);
a first thin film transistor (200) and a second thin film transistor (300) disposed on the substrate (101);
a light emitting device disposed on the first thin film transistor (200) and the second thin film transistor (300) and comprising a first electrode (E1), an emission layer (EL) and a second electrode (E2); and
an encapsulation layer disposed on the light emitting device,
wherein the first electrode (E1), the emission layer (EL) and the second electrode (E2) are formed to have a concave-convex structure in at least a portion of an emission region.

2. The display apparatus according to claim 1, further comprising a first insulation layer (125) disposed under the first electrode (E1), the first insulation layer (125) having a concave-convex structure corresponding to the concave-convex structure.

3. The display apparatus according to claim 2, further comprising one or more protrusion portions (124) disposed under the concave-convex structure of the first insulation layer (125).

4. The display apparatus according to claim 3, wherein a taper of the first insulation layer (125) is formed to be high on the one or more protrusion portions (124), and/or a thickness of the first insulation layer (125) is formed to be thick on the one or more protrusion portions (124).

5. The display apparatus according to claim 3 or 4, further comprising an auxiliary protrusion portion (126), the auxiliary protrusion portion (126) being disposed on the first insulation layer (125) and under the first electrode (E1) in the emission region, and overlapping the one or more protrusion portions (124).

6. The display apparatus according to claim 5, wherein a curvature radius of the auxiliary protrusion portion (126) in a thickness direction thereof is less than a curvature radius of the first insulation layer (125) in a thickness direction thereof.

7. The display apparatus according to any of claims 3 to 6, wherein the one or more protrusion portions (124), the first insulation layer (125) and the first electrode (E1) are disposed on a second insulation layer (123), and the display apparatus further comprises a first bank (127) defining the emission region, the first bank (127) being disposed to cover an edge portion of the first electrode (E1) and having a step height relative to the second insulation layer (123),
wherein the emission layer (EL) is disposed on the first electrode (E1) and the first bank (127).

8. The display apparatus according to claim 7, further comprising: a second bank (129) disposed on the first bank (127); and spacers (131) disposed on the second bank (129),
wherein the emission layer (EL) is disposed on the first electrode (E1), the first bank (127), the second bank (129) and the spacers (131), and is disposed in a trench (TR) formed by the spacers (131) and the second bank (129).

9. The display apparatus according to claim 8, wherein the first bank (127) is a black bank and the second bank (129) is a transparent bank.

10. The display apparatus according to any of claims 7 to 9, wherein the first insulation layer (125) is disposed under the first electrode (E1) and the first bank (127) in a non-emission region and further includes an inclined region, and the first electrode (E1) is disposed in the inclined region of the first insulation layer (125).

11. The display apparatus according to any of claims 7 to 10, further comprising: a connection electrode (122) which is disposed between the second insulation layer (123) and a third insulation layer (121) below the second insulation layer (123).

12. The display apparatus according to claim 11, further comprising: a second protrusion portion (124) disposed under the first insulation layer (125) and on the second insulation layer (123) in a non-emission region and passing through the second insulation layer (123), wherein the first electrode (E1) and the second thin film transistor (300) are electrically connected though the second protrusion portion (124) and the connection electrode (122).

13. The display apparatus according to claim 11 or 12, further comprising: a third protrusion portion (124) disposed in a non-display area of the display apparatus and used as a signal line, the third protrusion portion (124) being provided on a same layer as the one or more protrusion portions (124) and having a same material as the one or more protrusion portions (124), and being connected to the connection electrode (122).

14. The display apparatus according to claim 3, or any of claims 4 to 13 referring directly or indirectly back to claim 3, wherein subpixels in the display apparatus have different emission areas, and a subpixel having a larger emission area comprises more of the one or more protrusion portions (124).

15. The display apparatus according to claim 3, or any of claims 4 to 14, referring directly or indirectly back to claim 3, wherein a planar shape of the one or more protrusion portions (124) is a square shape, a circular shape, an oval shape, a cylindrical shape or other polygonal shapes, and/or
a cross-sectional shape of the one or more protrusion portions (124) is a rectangular shape, a square shape, a semicircular shape, a semi-oval shape or other polygonal shapes.
